# EUROPÄISCHE PATENTSCHRIFT

(11) **EP 2 556 288 B1**
(45) Veröffentlichungstag und Bekanntmachung des Hinweises auf die Patenterteilung: **10.06.2015**
(21) Anmeldenummer: 11713277.9
(22) Anmeldetag: 08.04.2011
(51) Int. Cl.: F21S 2/00, F21Y 101/02

(54) **LEUCHTMODUL UND LEUCHTE**
LIGHTING MODULE AND LUMINAIRE
MODULE D'ÉCLAIRAGE ET LAMPE

(30) Priorität: 10.04.2010 DE 102010014611; 09.04.2010 EP 10003829
(43) Veröffentlichungstag der Anmeldung: 13.02.2013
(73) Patentinhaber: Tridonic Dresden GmbH & Co. KG, 01099 Dresden (DE)
(72) Erfinder: KIRCHHOF, Christian, 01099 Dresden (DE); AMELUNG, Jörg, 01099 Dresden (DE)
(74) Vertreter: Thun, Clemens
(86) Internationale Anmeldenummer: PCT/EP2011/055525
(87) Internationale Veröffentlichungsnummer: WO 2011/124689

(56) Entgegenhaltungen:
- WO-A2-2007/069130
- DE-A1-102007 041 136
- US-A1- 2003 193 789

## Beschreibung

Die vorliegende Erfindung bezieht sich auf ein Leuchtmodul und eine Leuchte mit einer Mehrzahl von Leuchtmodulen, vorzugsweise Modulen mit Leuchtdioden und/oder Modulen mit organischen Leuchtdioden.

Auf der Basis organischer Leuchtdioden, sog. OLEDs (Organic Light Emitting Diodes), können neuartige Flächenlichtelemente verwirklicht werden. Als flächiger Leuchtkörper mit gegenüber einer anorganischen LED moderater Leuchtdichte ist die OLED ideal geeignet für die Herstellung flächiger diffuser Lichtquellen. Insbesondere im professionellen Beleuchtungsbereich ist eine diffuse Beleuchtung eine neue Möglichkeit der Realisierung von großflächigen hochqualitativen Leuchten. Hierbei können in weiterer Zukunft organische Leuchtdioden durch ihre Dünnschichttechnologie auch die Realisierung von flexiblen Leuchtkörpern ermöglichen, die ganz neue Anwendungen in der Beleuchtung von Räumen gestatten.

Analog zu anorganischen LEDs sind OLEDs stromgetriebene Bauelemente, d.h. die Leuchtdichte der OLED ist mit dem durch die lichtemittierende, aktive Schicht der OLED fließenden Strom korreliert. Um eine über ihre Fläche gleichmäßig Licht abstrahlende OLED zu realisieren, ist es erforderlich, eine über die Fläche der OLED homogene Stromdichteverteilung bereitzustellen. Dies stellt aber insbesondere bei der Herstellung großflächiger Leuchtelemente eine Herausforderung dar. Typischerweise weist eine OLED mindestens eine transparente Elektrode auf, die beispielsweise mittels eines transparenten leitfähigen Oxids (TCO = Transparent Conductive Oxide) oder mittels durchsichtiger Metallschichten realisiert wird. Da die elektrische Leitfähigkeit dieser transparenten Elektrodenmaterialien allerdings gering ist, ist die Homogenität der Stromdichteverteilung limitiert. Bei geforderter Homogenität der Leuchtdichte ist dadurch die maximal erreichbare Leuchtflächengröße beschränkt.

Ein Standardaufbau einer OLED weist beispielsweise eine organische Schicht zwischen einer transparenten ITO-Elektrode (ITO = Indium-Zinn-Oxid) und einer metallischen Kathode auf. Durch Anlegen einer geeigneten Spannung zwischen diesen beiden Elektroden wird innerhalb der organischen Schicht elektromagnetische Strahlung emittiert, insbesondere Licht im optisch sichtbaren Bereich oder Infrarotstrahlung. Die ITO-Elektrode kann auf Glas mit einer Dicke von ca. 100 nm aufgebracht sein. Die organische Schicht kann eine Mehrzahl von Teillagen, beispielsweise bis zu sieben Teillagen und eine Dicke von 100 bis 200 nm aufweisen. Die metallische Kathode kann beispielsweise eine Dicke von 100 bis 500 nm aufweisen und aus Aluminium bestehen. Eine derartige bzw. vergleichbar aufgebaute OLED kann auch als OLED-Panel bezeichnet werden.

Bei großflächigen Leuchtelementen führt nun der hochohmige Widerstand der ITO-Schicht zu einer Inhomogenität der Stromeinspeisung, da die Kontakte der ITO-Schicht nur am Rand des Leuchtelements möglich sind. Dies limitiert die maximale Größe einer gleichmäßig leuchtenden OLED auf ca. 50 x 50 mm².

Um Leuchtelemente mit größerer Lichtabstrahlfläche zu erzielen können insbesondere Metallverstärkungen in Form von Netzen in die ITO-Schicht eingebracht werden. Diese Metallverstärkungen, die auch als "Metallgrids" oder "Busbars" bezeichnet werden, erniedrigen den effektiven Schichtwiderstand entsprechend deren Belegungsdichte und ermöglichen somit die Realisierung größerer Diodenflächen. Aufgrund der Nichttransparenz dieser Verstärkungen erniedrigen sie jedoch die effektive Leuchtfläche. Aus diesem Grund sind Metallverstärkungen bis ca. 25 % der ITO-Fläche überhaupt sinnvoll. Eine mögliche Verbesserung wäre die Erhöhung der Verstärkungsmetalldicke. Dies ist aber aufgrund der Strukturierungsmöglichkeiten und der Schichtdicken der organischen Schichten nicht sinnvoll. Weiterhin wird die metallverstärkte ITO-Schicht nur an den Außenkanten kontaktiert, was trotz der effektiven Widerstandserniedrigung die maximale Leuchtelementfläche limitiert.

Zur Erreichung von Leuchtelementen mit großer Lichtabstrahlfläche können große OLED-Flächen in mehrere kleinere Einzel-OLED-Flächen, die im Folgenden als OLED-Module bezeichnet werden, unterteilt werden. Aufgrund der kleineren Größe einer Einzel-OLED-Fläche ist es nun verhältnismäßig einfacher, diese Einzel-OLED-Fläche als gleichmäßig leuchtende OLED zu realisieren. Werden diese Einzel-OLED-Flächen (OLED-Module) zu einer größeren Leuchtfläche zusammengeschlossen, so ist zur effizienten Ansteuerung ein elektrisches Kontaktierungssystem erforderlich.

Bekannte Kontaktkonfigurationen beziehen sich auf Kontaktierungstechniken auf dem OLED-Panel selbst, also auf dem Glassubstrat oder einer OLED-Untergrundfolie. Außenkontakte werden über Federkontakte oder ähnliche elektrische Kontakte mit einer Verteilerplatte verbunden. Da über diese Kontakte der Gesamtstrom für Anode und Kathode zugeführt bzw. abgeleitet wird, muss der Kontakt mindestens zweigeteilt sein. In einer gängigen Standardform werden zwei sich gegenüberliegende Kanten mit der Anode und zwei sich gegenüberliegende Kanten, die sich normal zu den Kanten mit der Anode befinden, mit der Kathode verbunden. Dies führt zu nicht optimalen Anschlüssen, da die Anschlusswiderstände zwischen Kathode und Anode unterschiedlich sind. Weiterhin ist eine solche Anordnung der Kontakte nicht verpolungssicher. Wird die Platte um 90° gedreht und mit den Außenkontakten in Verbindung gebracht, so führt dies zu einer Verpolung der Leuchtplatte.

Eine Modifikation einer solchen Kontaktkonfiguration besteht darin, jeweils einen Kontakt an zwei gegenüberliegenden Seiten einer Platte vorzusehen, wie dies beispielsweise in Fig. 7 der EP-A 1-1367674 zu entnehmen ist. Eine andere bekannte Kontaktkonfiguration führt alle Kontakte zu einer Seite einer Leuchtplatte, wie dies beispielsweise den Fig. 2 und 6 der EP-A-1367674 zu entnehmen ist.

Bei einer Kontaktierung mehrerer Panels als OLED-Module liegt das Augenmerk auf einer einfachen Kontaktierung. So offenbart die US-B2-7271534 eine einfache segmentierte Anschlusskonfiguration, die aber nicht lösbar ist. Die DE-A1-102007061473 offenbart eine strahlungsemittierende Vorrichtung, die einen Rahmen aufweist, in dem Stegstrukturen vorgesehen sind, um Teilbereiche zu definieren, die größenmäßig so ausgelegt sind, dass sie die Aufnahme strahlungsemittierender organischer Bauelemente ermöglichen. Jeder einen Teilbereich umschließende Rand weist an allen Seiten einen leitenden Bereich auf, wobei die strahlungsemittierenden organischen Bauelemente über diese leitenden Bereiche kontaktiert werden. Derartige Systeme ermöglichen jedoch weder eine Einbindung eines Steuerungs- bzw. Bussystems noch wird eine indirekte Kontaktierung der OLED-Panels durchgeführt.

Aus der US 2003/0193789 A1 ist ein Leuchtmodul bekannt, das randseitig Stromzuleitungs- und Stromableitungsanschlüsse aufweist. Das Leuchtmodul weist einen Modulkörper auf, der drehsymmetrisch geformt ist.

Aus der WO 2007/069130 A2 ist ein Beleuchtungssystem mit Leuchtmodulen bekannt, die über randseitige Anschlüsse miteinander elektrisch verbunden sind.

Aus der DE 10 2007 041 136 A1 ist ein LED-Gehäuse mit Gehäuseanschlusselementen bekannt.

Es besteht somit ein Bedarf nach einer Möglichkeit, einzelne OLED-Module, die für großflächige Leuchtelemente geeignet sind, zu kontaktieren und insbesondere verpolungssicher zu kontaktieren.

Ein weiterer Bedarf besteht nach einer Leuchte, insbesondere einer großflächigen Leuchte, mit entsprechenden Modulen.

Erfindungsgemäß wird dieser Bedarf durch ein Leuchtmodul nach Anspruch 1 sowie eine Leuchte nach Anspruch 11 gelöst.

Ausführungsbeispiele der Erfindung schaffen ein Leuchtmodul mit folgenden Merkmalen:
- einem Modulkörper,
- einem ersten Anschlusspaar bestehend aus einem ersten Stromzuleitungsanschluss und einem ersten Stromableitungsanschluss, sowie
- mindestens einem zweiten Anschlusspaar bestehend aus einem zweiten Stromzuleitungsanschluss sowie einem zweiten Stromableitungsanschluss, wobei die Anordnung der Anschlusspaare an dem Modulkörper eine der Anzahln der Anschlusspaare entsprechende n-zählige Drehsymmetrie aufweist.

Die Stromzuleitungsanschlüsse und die Stromableitungsanschlüsse sind auf einer Hauptoberfläche des Modulkörpers gebildet. Der erste und zweite Stromzuleitungsanschluss erstrecken sich dabei von der jeweils benachbarten Seite unterschiedlich weit in Richtung zu der gegenüberliegenden Seite, als sich der erste und der zweite Stromableitungsabschnitt von der jeweils benachbarten Seite zu der gegenüberliegenden Seite erstrecken.

Dabei können die Anschlusspaare an Seiten bzw. Seitenabschnitten des Modulkörpers angeordnet sein und die Form des Modulkörpers selbst eine n-zählige Drehsymmetrie aufweisen.

Beispielsweise wird also gemäß einem ersten speziellen Ausführungsbeispiel ein Leuchtmodul vorgeschlagen mit:
- einem Modulkörper, der zumindest vier Seiten aufweist, von denen sich eine erste Seite und eine zweite Seite gegenüberliegen;
- einem ersten Stromzuleitungsanschluss, der benachbart zu der ersten Seite gebildet ist;
- einem zweiten Stromzuleitungsanschluss, der benachbart zu der zweiten Seite gebildet ist;
- einem ersten Stromableitungsanschluss, der benachbart zu der ersten Seite gebildet ist; und
- einem Stromableitungsanschluss, der benachbart zu der zweiten Seite gebildet ist,
wobei sich der erste Stromzuleitungsanschluss und der zweite Stromableitungsabschluss gegenüberliegen und wobei sich der zweite Stromzuleitungsanschluss und der erste Stromableitungsanschluss gegenüberliegen. Bei diesem Beispiel ist ein verpolsicheres Anschließen möglich, unabhängig davon, ob das Leuchtmodul um 180° verdreht ist oder nicht.

In einer Weiterbildung kann dieses spezielle Modul ferner dritte und vierte Stromzuleitungsanschlüsse und Stromableitungsanschlüsse auf einer dritten und vierten Seite, die einander gegenüberliegen, aufweisen, so dass sich wiederum jeweils Stromzuleitungsanschlüsse und Stromableitungsanschlüsse gegenüberliegen. Hierbei ist dann ein verpolsicheres Anschließen möglich, unabhängig davon, ob das Leuchtmodul in 90°-Schritten verdreht ist oder nicht. Wie bereits oben erwähnt ist die Erfindung allerdings nicht auf derartige 2- bzw. 4-zählige Drehsymmetrien beschränkt sondern kann generell auf n-zählige Drehsymmetrien erweitert werden.

Eine entsprechende erfindungsgemäße Anordnung von Stromzuleitungsanschlüssen und Stromableitungsanschlüssen ermöglicht somit eine sichere und effektive Verschaltung von größeren OLED-Flächen mittels eines verpolungssichereren Verschaltungssystems. Mit anderen Worten ist ein Anschluss eines erfindungsgemäßen Leuchtmoduls, beispielsweise zur Implementierung eines großflächigen Leuchtkörpers, möglich, unabhängig davon, ob das Leuchtmodul in einer Ebene, die bezüglich einer Hauptfläche desselben parallel ist, verdreht ist oder nicht.

Bei Ausführungsbeispielen der Erfindung weist das Leuchtmodul eine lichtemittierende Diode und insbesondere eine OLED auf, wobei die Stromzuleitungsanschlüsse Anodenanschlüsse und die Stromableitungsanschlüsse Kathodenanschlüsse sind. Eine Mehrzahl entsprechender Leuchtmodule, die OLEDs aufweisen, können verschaltet werden, um großflächige Leuchtkörper zu implementieren.

Ausführungsbeispiele der vorliegenden Erfindung schaffen ferner eine Leuchte mit folgenden Merkmalen:
- einer Mehrzahl von entsprechenden Leuchtmodulen; und
- Verbindungsstrukturen, die einen Stromableitungsanschluss eines vorgeschalteten Leuchtmoduls jeweils mit einem Stromzuleitungsanschluss eines nachgeschalteten Leuchtmoduls elektrisch verbinden, so dass die Leuchtmodule in Reihe geschaltet sind.

Die Verbindungsstrukturen können ausgelegt sein, um eine nicht lösbare Verbindung oder eine lösbare Verbindung zu liefern.

Bei Ausführungsbeispielen der Erfindung erstrecken sich Stromzuleitungsanschlüsse und Stromableitungsanschlüsse unterschiedlich weit von dem jeweils zugeordneten Rand weg, so dass ein stromführender Teil der Kontaktierung immer außerhalb der Kontaktierung der Masse liegt, so dass eine Verpolung des Systems unmöglich ist.

Bei Ausführungsbeispielen der Erfindung weisen die Leuchtmodule ferner einen oder mehrere Steuerbusanschlüsse auf, die jeweils benachbart zu der ersten und der zweiten Seite angeordnet sind. Diese Steuerbusanschlüsse können derart ausgebildet sein, dass bei einer Verdrehung des Leuchtmoduls - beispielsweise um 180° - ein Bus nicht angeschlossen ist. Zu diesem Zweck kann sich ein Steuerbusanschluss weiter von der ihm benachbarten Seite in Richtung der der ihm gegenüberliegenden Seite erstrecken, als ein Steuerbusanschluss, der bei einer Drehung des Leuchtmoduls um 180° an der Position dieses Steuerbusanschlusses zu liegen kommt. Bei Ausführungsbeispielen der Erfindung können die Leuchtmodule oder eine Halterung für die Leuchtmodule eine entsprechende Logikschaltung aufweisen, um einen Anschluss der Leuchtmodule an einen Steuerbus zu ermöglichen, um die Integrierung eines Lichtsteuer- oder Sensorbusses für eine professionelle Ansteuerung von großen Lichtflächen zu ermöglichen. Beispielsweise ermöglichen Ausführungsbeispiele der Erfindung einen Anschluss an bekannte professionelle Lichtansteuerungen, beispielsweise in der Form eines DALI-Busses, (DALI = digital addressable lighting interface) oder eines DMX-Busses (DMX = digital multiplex).

Bevorzugte Ausführungsbeispiele der vorliegenden Erfindung werden nachfolgend bezugnehmend auf die beiliegenden Zeichnungen näher erläutert. Es zeigen:
Fig. 1 schematisch eine Serienschaltung mehrerer Leuchtmodule;
Fig. 2a und 2b schematische Darstellungen zur Veranschaulichung des Aufbaus eines Ausführungsbeispiels eines Leuchtmoduls;
Fig. 3 schematisch eine Unteransicht eines Ausführungsbeispiels eines Leuchtmoduls;
Fig. 4 schematisch eine Unteransicht eines weiteren Ausführungsbeispiels eines Leuchtmoduls;
Fig. 4a bis 4c weitere Ausführungsbeispiele eines erfindungsgemäßen Leuchtmoduls;
Fig. 5 schematisch eine Darstellung eines Ausführungsbeispiels einer Leuchte;
Fig. 6 schematisch eine Darstellung eines Ausführungsbeispiels einer Leuchte;
Fig. 7a und 7b schematische Darstellungen zur Veranschaulichung eines Ausführungsbeispiels der Erfindung mit unlösbarer Kontaktierung; und
Fig. 8a und 8b schematische Darstellungen zur Veranschaulichung eines Ausführungsbeispiels mit lösbarer Kontaktierung.

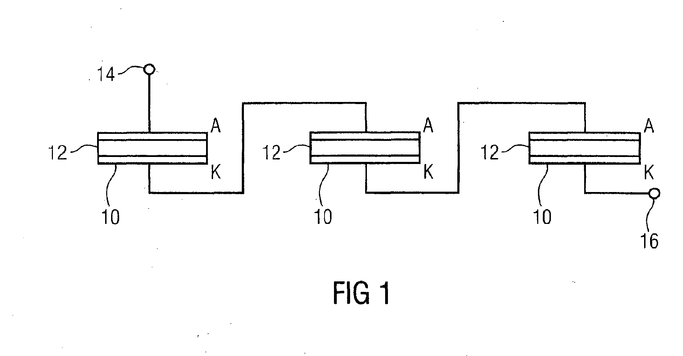

Die Ausführungsbeispiele der Figuren 1-6 werden nicht beansprucht.

Fig. 1 zeigt schematisch eine Serienschaltung von drei Leuchtmodulen 10, die beispielsweise durch OLED-Panels gebildet sein können. Jedes Leuchtmodul weist eine OLED mit einem Anodenanschluss A, einem Kathodenanschluss K und einem aktiven Bereich 12 auf. Die OLEDs können einen herkömmlichen Aufbau aufweisen, wie er oben beschrieben ist. Der Anodenanschluss A des ersten Leuchtmoduls und der Kathodenanschluss K des letzten Leuchtmoduls sind mit entsprechenden Potentialen 14 und 16 verbunden, sodass die OLEDs in Flussrichtung gepolt sind und somit Licht emittieren. Die Anode A jeder OLED stellt dabei einen Stromzuleitungsanschluss dar und die Kathode jeder OLED stellt einen Stromableitungsanschluss dar. Wie in Fig. 1 gezeigt ist, ist jeweils die Kathode einer vorgeschalteten OLED mit der Anode einer nachgeschalteten OLED verbunden, sodass die OLEDs in Reihe verschaltet sind.

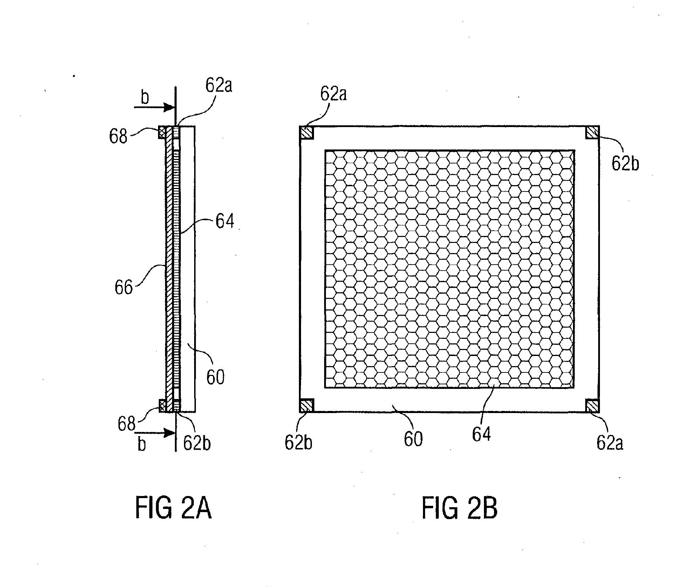

Die Fig. 2a und 2b zeigen schematisch Darstellungen zur Veranschaulichung eines Leuchtmoduls. Dabei zeigt 2a eine Seitenansicht, während Fig. 2b eine Schnittansicht entlang einer Linie b-b von Fig. 2a zeigt.

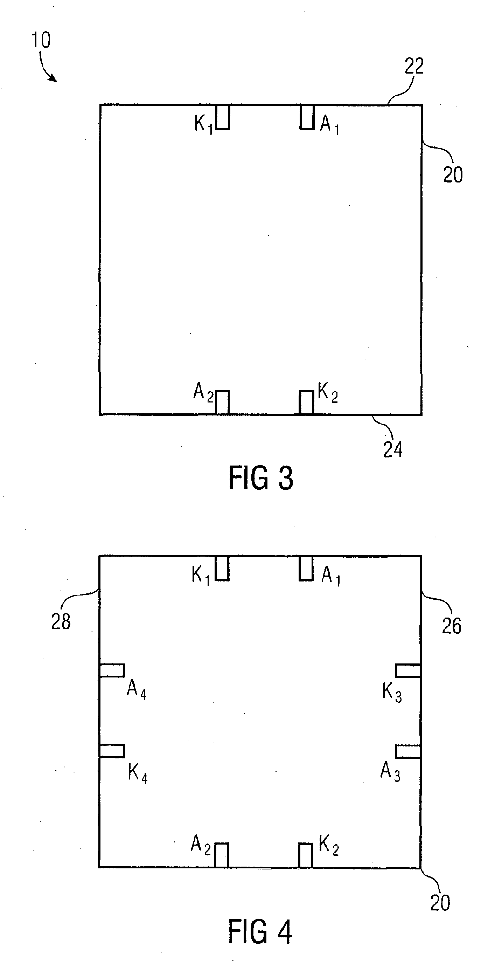

Wie in den Fig. 2a und 2b gezeigt ist, kann das Leuchtmodul ein OLED-Panel 60 aufweisen, das auch als OLED-Platte oder OLED-Folie bezeichnet werden kann. Das OLED-Panel weist elektrische Kontakte 62a, 62b an allen vier Ecken auf, wobei Kontakte 62a Anodenkontakte und Kontakte 62b Kathodenkontakte darstellen können. Die Anordnung der Anodenkontakte und Kathodenkontakte auf dem OLED-Panel ist jedoch unerheblich und kann von der beschriebenen Anordnung abweichen. Das OLED-Panel 60 weist flächige Elektroden (nicht gezeigt) auf, die eine homogene Stromeinspeisung in einen dazwischen angeordneten aktiven Bereich ermöglichen. Eine der flächigen Elektroden ist mit den Anodenkontakten 62a verbunden und eine der flächigen Elektroden ist mit den Kathodenkontakten 62b verbunden. Das OLED-Panel 60 ist über einen Kleber 64, der ein thermisch leitender Kleber sein kann, mit einer Platine 66 mechanisch verbunden. Die Platine 66 liefert eine elektrische Verbindung zwischen Anschlüssen 68, die auf einer von dem OLED-Panel 60 abgewandten Hauptfläche der Platine 66 angeordnet sind, und den Anodenkontakten und Kathodenkontakten 62a und 62b. Genauer gesagt weisen die Anschlüsse 68 Anoden- bzw. Stromzuleitungsanschlüsse auf, die mit den Anodenkontakten 62a verbunden sind, und Kathoden- bzw. Stromableitungsanschlüsse, die mit den Kathodenkontakten 62b verbunden sind. Die Anodenanschlüsse und Kathodenanschlüsse des Leuchtmoduls können auf die Weise auf der von dem OLED-Panel abgewandten Seite angeordnet sein, wie sie hierin bezugnehmend auf die Fig. 3, 4, 7a, 7b, 8a und 8b beschrieben wird. Die Platine 66 liefert somit eine Verdrahtung zwischen den Kontakten des OLED-Panels und den erfindungsgemäß angeordneten Anodenanschlüssen bzw. Kathodenanschlüssen. Durch die erfindungsgemäße Anordnung der Kathoden- und Anodenanschlüsse wird eine für einen Leuchtenhersteller benutzerfreundliche Kontaktierung, beispielsweise mittels Federkontakten, ermöglicht. Die Anordnung der Kathoden- und Anodenanschlüsse kann dabei standardisiert werden. Gleichzeitig wird mittels der Platine der Strom auf ein oder mehrere Kontaktierungspunkte 62a, 62b des OLED-Panels verteilt, die so am OLED-Panel angeordnet sind, damit eine optimale Stromeinspeisung ermöglicht wird. Die Kontaktierungspunkte 62a und 62b am OLED-Panel können dabei individuell an das jeweils verwendete OLED-Panel angepasst sein.

Die Platine kann neben der Verdrahtungsfunktion zur mechanischen Stabilisierung dienen. Ferner kann sie bevorzugt aus gut wärmeleitfähigem Material aufgebaut sein bzw. Bereiche aufweisen, die Wärme gut weiterleiten, um die im Betrieb des OLED-Panels entstehende Wärme effizient weiterleiten bzw. abführen zu können. Weiters können Logikschaltungen in die Platine integriert sein.

Fig. 3 zeigt schematisch eine Hauptfläche eines Modulkörpers 20 eines Leuchtmoduls 10, der eine erste Seite 22 und eine zweite Seite 24, die sich gegenüberliegen und parallel zueinander sind, aufweist. Der Modulkörper 20 kann beispielsweise durch die Platine 66 gebildet sein. Bei alternativen Ausführungsbeispielen, die keine Platine aufweisen, kann der Modulkörper durch das OLED-Panel gebildet sein.

Benachbart zu der ersten Seite 22 ist ein erster Kathodenanschluss K1 und ein erster Anodenanschluss A1 vorgesehen. Benachbart zu der zweiten Seite 24 ist ein zweiter Kathodenanschluss K2 und ein zweiter Anodenanschluss A2 vorgesehen. Unter "benachbart" sei in diesem Zusammenhang eine Anordnung zu verstehen, bei der die entsprechenden Elektrodenanschlüsse zumindest näher an der benachbarten Seite angeordnet sind als an der gegenüberliegenden Seite. Bei Ausführungsbeispielen der Erfindung erstrecken sich die Anschlüsse jeweils vom benachbarten Rand weg in Richtung zu der gegenüberliegenden Seite. Alternativ könnten die Anschlüsse jedoch auch mit einem Abstand zum Rand angeordnet sein.

Wie in Fig. 3 zu erkennen ist, liegt der erste Anodenanschluss A1 dem zweiten Kathodenanschluss K2 gegenüber, und der erste Kathodenanschluss K1 liegt dem zweiten Anodenanschluss A2 gegenüber. Verdreht man den Modulkörper 20 um 180°, so kommt der Kathodenanschluss K2 an der Position des Kathodenanschlusses K1 zu liegen und der Anodenanschluss A2 kommt an der Position des Anodenanschlusses A1 zu liegen. Somit ermöglicht eine Anschlusskonfiguration, wie es in Fig. 3 gezeigt ist, eine verpolungssichere Verschaltung, da unerheblich ist, ob das Leuchtmodul, ausgehend von dem in Fig. 3 gezeigten Zustand, um 180° verdreht ist oder nicht.

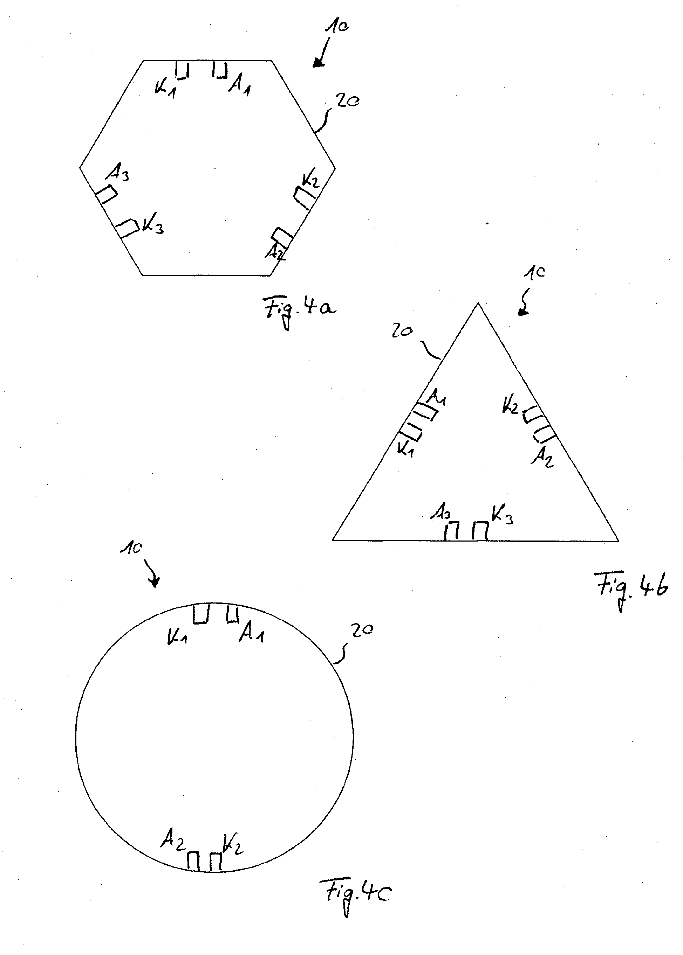

Fig. 4 zeigt schematisch eine Hauptfläche eines Modulkörpers 20 eines alternativen Ausführungsbeispiels der Erfindung. Bei diesem Ausführungsbeispiel sind Kathodenanschlüsse K3, K4 und Anodenanschlüsse A3, A4 auch auf einer dritten Seite 26 und einer vierten Seite 28, die sich gegenüberliegen, vorgesehen. Der dritte Kathodenanschluss K3 liegt dem vierten Anodenanschluss A4 gegenüber, und der dritte Anodenanschluss A3 liegt dem vierten Kathodenanschluss K4 gegenüber. Bei einer Drehung des in Fig. 4 gezeigten Modulkörpers um jeweils 90° kommen jeweils Anodenanschlüsse und Kathodenanschlüsse an gleichen Positionen zu liegen, so dass hier eine Verpolsicherheit auch bei Drehungen um 90° erreicht werden kann.

Bei Seiten, die sich gegenüberliegen und die im wesentlichen parallel zueinander sind, ist im Rahmen dieser Offenbarung unter dem Ausdruck "gegenüberliegen" im Zusammenhang mit den jeweiligen Anschlüssen zu verstehen, dass sich diese auf einer gedachten Linie, die im Wesentlichen senkrecht zu den Seiten, zu denen die Anschlüsse benachbart sind, gegenüberliegen.

Allgemein ausgedrückt sind somit die Anodenanschlüsse jeweils derart angeordnet, dass sie bei einer Drehung in einer Ebene parallel zu den Hauptoberflächen der Leuchtmodule um 180° bzw. 90° an gleichen Positionen (entlang des Umfangs der Leuchtmodule) zu liegen kommen. Selbiges gilt für die Kathodenanschlüsse. Somit ist eine verpolungssichere Kontaktierung möglich, unabhängig davon, ob die Leuchtmodule in der Ebene der Hauptoberflächen derselben um jeweils 180° bzw. 90° verdreht sind oder nicht.

In Fig. 3 und 4 wurde ein Modulkörper mit vier Seiten beschrieben, wobei die im Zusammenhang mit diesen Figuren erläuterte Anordnung der Anschlüsse bzw. Anschlusspaare eine sogenannte Drehsymmetrie aufweist, wobei in Fig. 3 eine 2-zählige Drehsymmetrie und in Fig. 4 eine 4-zählige Drehsymmetrie vorliegt. Unter einer derartigen sog. n-zähligen Drehsymmetrie wird allgemein verstanden, dass sich bei einer Verdrehung des Moduls um einen Winkel α = 360°/n oder eines ganzzahligen Vielfachen davon wieder eine gleiche Anordnung der Anschlüsse ergibt wie zuvor.

Es ist nun ein wesentlicher Gedanke der vorliegenden Erfindung, dass das erfindungsgemäße Konzept der speziellen Anordnung der Anschlüsse nicht auf 2- oder 4-zählige Drehsymmetrien beschränkt ist, sondern generell auf n-zählige Drehsymmetrien erweitert werden kann, wobei n dann auch der Anzahl der Anschlusspaare entspricht. So kann bei alternativen Ausführungsbeispielen der Modulkörper auch mehr Seiten, beispielsweise 5, 6 oder 8 Seiten aufweisen, wobei entsprechende Anodenanschlüsse und Kathodenanschlüsse dann wiederum derart angeordnet sind, dass eine Verdrehung um 72°, 60° bzw. 40° wiederum zu der gleichen Anordnung der Anschlüsse führt. Auch eine Variante wie in Figur 4a dargestellt wäre denkbar, wobei die Anschlüsse entsprechend einer 3-zähligen Drehsymmetrie angeordnet sind. Ebenso ist eine Variante eines Modulkörpers mit 3 Seiten möglich, bei der der Modulkörper eine dreieckige Grundfläche aufweist (sihe Fig. 4b). An jeder Seite des Modulkörpers ist dabei jeweils ein Anoden- und ein Kathodenanschluss derart angeordnet, sodass bei einer Drehung in einer Ebene parallel zu der Hauptoberfläche des Leuchtmoduls um 120° bzw. 240° die Anoden- bzw. Kathodenanschlüsse jeweils an gleichen Positionen (entlang des Umfangs der Leuchtmodule) zu liegen kommen. Es liegt in diesem Fall eine 3-zählige Drehsymmetrie vor und die "gegenüberliegenden" Seiten des dreieckigen Modulkörpers sind in diesem Fall nicht parallel zueinander.

Es ist auch möglich, dass der Modulkörper eine andere Grundform als das OLED-Panel aufweist. Beispielsweise kann in einer alternativen Ausführungsform ein rundes OLED-Panel an einem Modulkörper mit viereckiger Grundform angeordnet sein oder die in einer n-zähligen Drehsymmetrie angeordneten Anschlüsse können auf einem runden Modulkörper angeordnet werden, wie dies in Fig. 4c der Fall ist. Die Form des Modulkörpers muss also nicht zwingend ebenfalls eine n-zählige Drehsymmetrie aufweisen, wobei jedoch eine Übereinstimmung hierbei eine bevorzugte Ausführungsform darstellt.

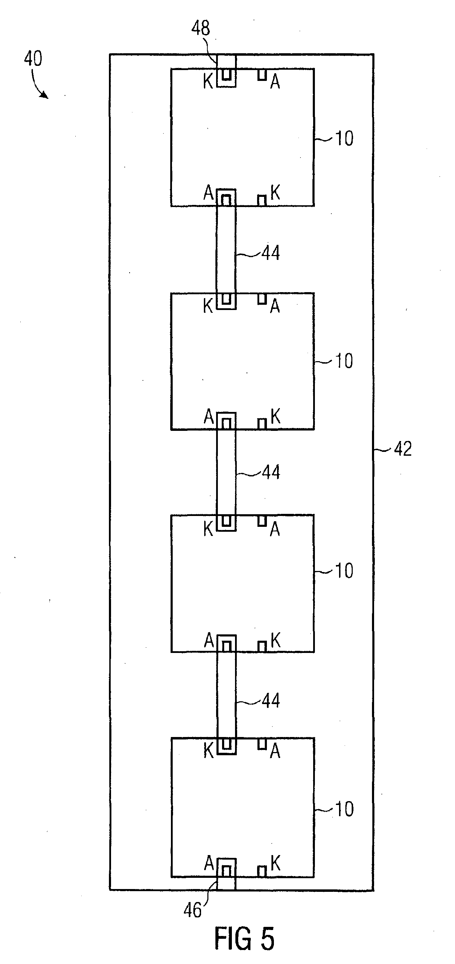

Fig. 5 zeigt ein Ausführungsbeispiel einer Leuchte 40, die vier Leuchtmodule 10, wie sie in Fig. 3 gezeigt sind, aufweist. Die Leuchte 40 umfasst eine Trägerplatte 42, auf der die Leuchtmodule 10 angeordnet sind. Auf der Trägerplatte 42 sind Verbindungsstrukturen 44 vorgesehen, mit denen jeweils die Kathode eines vorgeschalteten Leuchtmoduls mit der Anode eines nachgeschalteten Leuchtmoduls verbunden ist. Ferner ist in Fig. 5 eine Verbindungsstruktur 46 gezeigt, über die die Anode des ersten Leuchtmoduls mit einem entsprechenden Potential, beispielsweise einer positiven Versorgungsspannung, verbunden werden kann, während mit 48 eine Verbindungsstruktur gezeigt ist, über die die Kathode des letzten Leuchtmoduls mit einem entsprechenden Versorgungspotential, beispielsweise Masse, verbunden sein kann. Die Verbindungsstrukturen 44 können beispielsweise auf der Trägerplatte 40 vorgesehene Leiterbahnen sein, die nicht lösbar mit den entsprechenden Anschlüssen der Leuchtmodule verbunden sein können. Beispielsweise können die Leuchtmodule auf die Trägerplatte 40 aufgeklebt sein. Alternativ können die Verbindungsstrukturen für eine lösbare Verbindung, z.B. durch Federkontakte, ausgelegt sein. An dieser Stelle sei angemerkt, dass die Trägerplatte 40 und die darauf angeordneten Verbindungsstrukturen 44, 46 und 48 durchsichtig dargestellt sind, um die darunter angeordneten Leuchtmodule erkennen zu können.

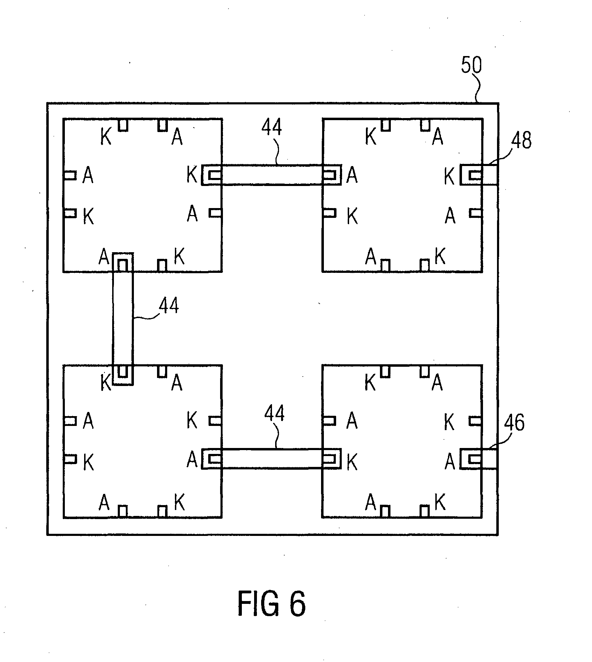

Fig. 6 zeigt eine schematische Darstellung eines alternativen Ausführungsbeispiels, bei dem vier Leuchtmodule, wie sie in Fig. 4 gezeigt sind, auf einer Trägerplatte 50 angeordnet sind, die wiederum entsprechende Verbindungsstrukturen 44, 46 und 48 aufweist. Während in Fig. 5 die Leuchtmodule in einer Reihe angeordnet sind, sind in Fig. 6 die Leuchtmodule in zwei Reihen angeordnet. Es ist offensichtlich, dass Ausführungsbeispiele der Erfindung somit ein Zusammenschalten einer Mehrzahl von Leuchtmodulen auf unterschiedliche und vielfältige Arten ermöglichen, um großflächige Leuchtkörper zu implementieren. Wie aus Fig. 5 zu erkennen ist, ist eine verpolsichere Verschaltung möglich, unabhängig davon, ob die Leuchtmodule um 180° verdreht sind oder nicht. Aus Fig. 6 ist zu erkennen, dass eine verpolsichere Verschaltung möglich ist, unabhängig davon, ob die Leuchtmodule um 90°, 180° oder 270° verdreht sind.

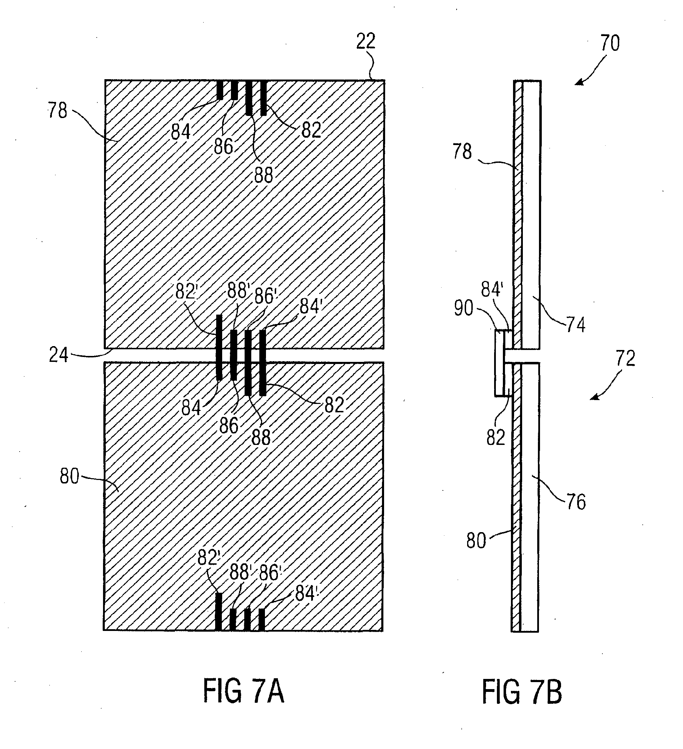

Die Fig. 7a und 7b zeigen schematisch ein alternatives Ausführungsbeispiel erfindungsgemäßer Leuchtmodule. Dabei sind in den Fig. 7a und 7b ein erstes Leuchtmodul 70 und ein zweites Leuchtmodul 72 gezeigt, die über Verbindungsstrukturen 90 verschaltet sind. Die Leuchtmodule weisen jeweils ein OLED-Panel 74 bzw. 76 und eine Platine 78 bzw. 80 auf. Die Kontakte (nicht gezeigt) der OLED-Panel 74 und 76 sind über die Platine 78 und 80 auf die Rückseite der Elemente geführt, um von da aus eine robuste Verschaltung realisieren zu können. Genauer gesagt sind bei diesem Ausführungsbeispiel an zwei sich gegenüberliegenden Seiten 22 und 24 des Modulkörpers 20 jeweils vier Kontakte bzw. Anschlüsse angebracht. Genauer gesagt sind die Anschlüsse auf der jeweiligen Platine 78 bzw. 80 ausgeführt.

Die zu der Seite 22 benachbarten Anschlüsse umfassen einen Stromzuleitungsanschluss 82, einen Stromableitungsanschluss 84, und zwei Steuerbusanschlüsse 86 und 88. Die zu der Seite 24 benachbarten Anschlüsse umfassen einen Stromzuleitungsanschluss 82', einen Stromableitungsanschluss 84', und zwei Steuerbusanschlüsse 86' und 88'.

In der Draufsicht von Fig. 7a sind die Verbindungsstrukturen 90 deckungsgleich mit den jeweils darunter angeordneten Anschlüssen dargestellt. Es sei jedoch ausgeführt, dass die Verbindungsstrukturen 90 flächenmäßig größer oder kleiner als die Anschlüsse sein können, solange eine elektrische Verbindung zwischen jeweiliger Verbindungsstruktur 90 und Anschluss 82 bis 88 bzw. 82' bis 88' geliefert wird.

Im Betrieb ist der Stromzuleitungsanschluss 82 mit einem solchen Potential verbunden, dass er eine Stromzuführung liefert, während der Stromableitungsanschluss 84' mit einem solchen Potential verbunden ist, z.B. Masse oder einem Stromzuleitungsanschluss eines nachgeschalteten Moduls, dass er eine Stromableitung liefert. Über die Steuerbusanschlüsse 86 und 88 kann ein Zweidrahtbus, beispielsweise ein Bus eines Dali-Bussystems oder eines DMX-Bussystems, kontaktiert werden. Entsprechende Anschlüsse sind auch auf den entsprechenden sich gegenüberliegenden Seiten des zweiten Leuchtmoduls 72 vorgesehen.

Wie in den Fig. 7a und 7b schematisch dargestellt ist, sind die Module über Verbindungsstrukturen 90 miteinander verbunden. Genauer gesagt, sind vier Verbindungsstrukturen vorgesehen, die die Kontakte 82', 84', 86' und 88' des Moduls 70 mit den Kontakten 82, 84, 86, 88 des Moduls 72 verbinden.

Wie in Fig. 7a zu erkennen ist, ist die Konfiguration bei den Leuchtmodulen derart, dass einem Stromzuleitungsanschluss 84 bzw. 84' innerhalb der Module jeweils ein Masseanschluss 82' bzw. 82 gegenüberliegt. Ferner ist die Konfiguration so ausgelegt, dass bei einer Aneinanderschaltung der Module 70 und 72 dem Stromableitungsanschluss 84' des Moduls 70 der Stromzuleitungsanschluss 82 des anderen Moduls 72 gegenüberliegt. Über eine Verbindung dieser Anschlüsse ist somit eine einfache Reihenschaltung ohne Kreuzungspunkte möglich. Ferner liegen sich der Anschluss 82' des Moduls 70 und der Anschluss 84 des Moduls 72 gegenüber und sind über eine Verbindungsstruktur 90 verbunden. An dieser Stelle sei jedoch angemerkt, dass diese Verbindung zur Implementierung der beschriebenen Reihenschaltung nicht erforderlich ist.

Durch die Verbindung der Steuerbusanschlüsse 86' und 88' des Leuchtmoduls 70 mit den Steuerbusanschlüssen 88 und 86 kann eine einfache Weiterleitung des Steuerbusses erreicht werden.

Durch die gezeigte Anordnung der Anschlüsse ist eine einfache Verbindung durch einfache Kontaktierung sämtlicher Anschlüsse beider Module möglich, ohne dass Überkreuzungen von Leitungen erforderlich sind.

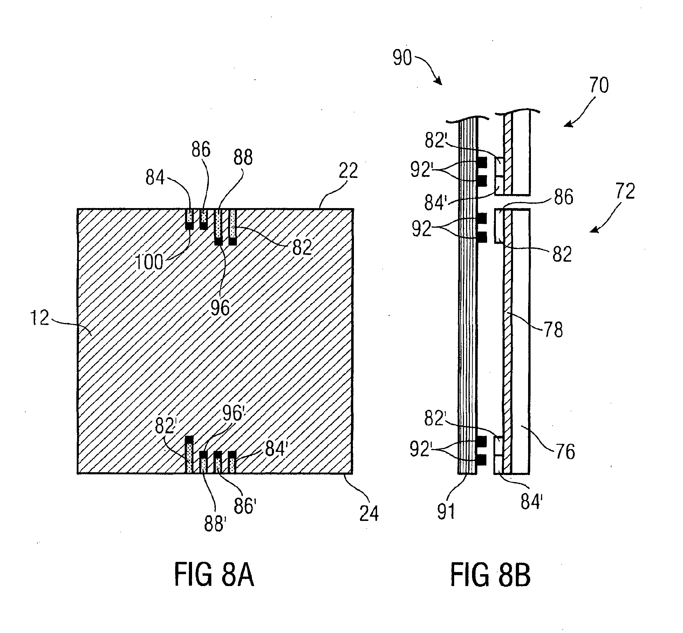

Wie in Fig. 7a zu erkennen ist, erstreckt sich der Stromleitungsanschluss 82 weiter von der Seite 22 weg als der Stromableitungsabschluss 84. Ferner erstreckt sich der Steuerbusanschluss 88 weiter von der Seite 22 weg als der Steuerbusanschlussanschluss 86. Bei dem gezeigten Ausführungsbeispiel besitzen die Anschlüsse 82 und 88 die gleiche Länge und die Anschlüsse 84 und 86 besitzen die gleiche Länge. Die Längen der Anschlüsse 82', 84' und 86' entsprechen denen der Anschlüsse 82, 84 und 86. Jedoch weist der Steuerbusanschluss 88' eine geringere Länge auf als der Steuerbusanschluss 86'. Auf die Bedeutung dieser speziellen Ausführung der Anschlüsse wird nachfolgend bezugnehmend auf die Fig. 8a und 8b näher eingegangen.

Bei dem in den Fig. 7a und 7b gezeigten Ausführungsbeispiel sind die Verbindungsstrukturen ausgelegt, um eine nichtlösbare Verbindung zwischen den Leuchtmodulen 70 und 72 zu liefern. Die Verbindungsstrukturen 90 können in geeigneter Weise auf einer Trägerplatte angeordnet sein, die beispielsweise mit den Leuchtmodulen verklebt werden kann, um sowohl eine mechanische Verbindung als auch die notwendigen elektrischen Verbindungen zu implementieren.

Die unterschiedlichen Längen der Anschlüsse sind insbesondere bei der Implementierung einer lösbaren Verbindung, wie sie nachfolgend bezugnehmend auf die Fig. 8a und 8b erläutert wird, von Vorteil. Alternativ können die Anschlüsse jeweils eine gleiche Länge aufweisen, d.h. sich gleich weit von dem jeweils benachbarten Rand weg erstrecken.

Die Fig. 8a und 8b zeigen schematische Darstellungen zur Veranschaulichung eines Ausführungsbeispiels eines verpolungssicheren Schaltungssystems mit lösbarer Kontaktierung. In der Draufsicht von Fig. 8a ist lediglich das Leuchtmodul 72 dargestellt, während in der Seitenansicht von Fig. 8b das Leuchtmodul 72 und ein unterer Teil des Leuchtmoduls 70 dargestellt ist.

Der Aufbau der Leuchtmodule 70 und 72 kann dabei dem Aufbau entsprechen, wie er oben bezugnehmend auf die Fig. 7a und 7b erläutert wurde.

Wie in Fig. 8b gezeigt ist, ist ein Kontaktierungshaltersystem 90 zum Implementieren von lösbaren Verbindungen vorgesehen. Das Kontaktierungshaltersystem 90 weist eine Trägerplatte 91 und Kontakte 92, 92' auf, die als Federkontakte ausgebildet sein können. Die Stellen, an denen die Kontakte des Kontaktierungshaltersystems 90 auf die Anschlüsse 82 bis 88 und 82' bis 88' der Platine treffen, sind zu Veranschaulichungszwecken in der Draufsicht von Fig. 8a als schwarze quadratische Punkte dargestellt.

Kontakte 92 sind mit jeweiligen Kontakten 92' durch leitfähige Verbindungen (nicht gezeigt) auf der Trägerplatte verbunden, um die erforderlichen elektrischen Verbindungen zwischen zwei Leuchtmodulen zu implementieren, um die Leuchtmodule in Reihe zu schalten. Dazu können auf oder in der Trägerplatte 91 entsprechende leitfähige Strukturen vorgesehen sein. Die Trägerplatte 91 kann dabei als ein einschichtiges oder mehrschichtiges Verdrahtungssubstrat ausgebildet sein.

So sind beispielsweise die Kontakte 92', die dem Leuchtmodul 70 gegenüberliegend dargestellt sind, mit den Kontakten 92, die dem Leuchtmodul 72 gegenüberliegend dargestellt sind, verbunden, um die entsprechenden Anschlüsse der beiden Leuchtmodule miteinander zu verbinden. Somit ist über die entsprechenden Versorgungsanschlüsse (Stromzuleitungsanschlüsse und Stromableitungsanschlüsse) eine Hintereinanderschaltung der Leuchtmodule möglich, während über die entsprechenden Steuerbusanschlüsse eine Einbindung in ein Steuerbussystem möglich ist.

Um eine entsprechende Verschaltung zu erreichen, werden die Leuchtmodule mechanisch mit dem Kontaktierungshalterungssystem gekoppelt, so dass die Federkontakte die entsprechenden Anschlüsse 82 bis 88 und 82' bis 88' treffen. Um dies zu veranschaulichen, sind die Stellen, an denen die Kontakte 92 bzw. 92' auf die Anschlüsse der Platine treffen, in Fig. 8a durch schwarze quadratische Punkte dargestellt, von denen einer mit dem Bezugszeichen 100 bezeichnet ist. Eine lösbare mechanische Verbindung bzw. Halterung zwischen den Leuchtmodulen 70, 72 und dem Kontaktierungshaltersystem 90 kann auf beliebige geeignete Weise erfolgen, beispielsweise durch geeignete Klemmvorrichtungen, Schnappvorrichtungen, Schraubvorrichtungen oder dergleichen. Solche Vorrichtungen können insbesondere den Austausch einzelner Leuchtmodule ermöglichen.

Wie Fig. 8a zu entnehmen ist, ist die Position der Anschlüsse 82 bis 88 und 82' bis 88' sowie der Kontakte 92 und 92' so ausgelegt, dass bei einer Verdrehung des Moduls um 180° kein Kurzschluss des Moduls zustande kommen kann und zusätzlich immer der stromführende Teil der Kontaktierung außerhalb des stromableitenden Teils (Masse) der Kontaktierung liegt, so dass eine Verpolung des Systems unmöglich ist. Dies wird erreicht, indem die Stromzuleitungsanschlüsse 82, 82' länger sind als die Stromableitungsanschlüsse 84, 84' und indem die Kontakte für die Stromzuleitungsanschlüsse hinsichtlich des jeweiligen Seitenrandes weiter nach innen versetzt sind als die Kontakte für die Stromableitungsabschlüsse.

Ferner ist der Steuerbusanschluss 88 länger als der Steuerbusanschluss 88', d.h. der Steuerbusanschluss 88 ragt weiter von der Seite 22 nach innen als der Steuerbusanschluss 88' von der Seite 24 nach innen ragt. Die Stellen, an denen den Anschlüssen 88 und 88' zugeordnete Kontakte auf dem Kontaktierungshaltersystem auf die Anschlüsse 88 und 88' treffen, sind in Fig. 8a mit den Bezugszeichen 96 und 96' bezeichnet. Die entsprechenden Kontakte sind auf dem Kontaktierungshaltersystem 90 derart angeordnet, dass sie einen unterschiedlichen Abstand vom jeweiligen Rand des Leuchtmoduls aufweisen, wenn das Leuchtmodul mit dem Kontaktierungshaltersystem in der richtigen Ausrichtung mechanisch gekoppelt ist. Ist das Leuchtmodul jedoch um 180° verdreht, so kontaktiert zumindest der bei richtiger Ausrichtung dem Anschluss 88 zugeordnete Kontakt den kürzeren Steuerbusanschluss 88' nicht, so dass ein Anschluss an den Steuerbus nicht stattfindet. Eine solche Vorgehensweise ist sinnvoll, wenn vorgegebene Polaritäten beim Anschluss des Steuerbusses eingehalten werden müssen. Müssen solche vorgegeben Polaritäten nicht eingehalten werden, beispielsweise bei der Verwendung eines Eindrahtbusses, können der oder die Steuerbusanschlüsse ausgebildet sein, um unabhängig von der Ausrichtung des Leuchtmoduls einen Anschluss des Steuerbusses zu ermöglichen.

Das Kontaktierungshaltersystem 90 kann eine Vielzahl von entsprechenden Kontakten beziehungsweise Kontaktierungspunkten aufweisen, um eine Vielzahl von Leuchtmodulen entsprechend den obigen Ausführungen zu verschalten. Insbesondere kann das Kontaktierungshaltersystem ausgebildet sein, um eine Vielzahl von Leuchtmodulen seriell zu verschalten. Bei Ausführungsbeispielen kann das Kontaktierungshaltersystem ferner ausgebildet sein, um die Integrierung eines Lichtsteuer- oder Sensorbusses (allgemein Steuerbusses) für eine professionelle Ansteuerung von großen Lichtflächen zu ermöglichen. Bei der Implementierung eines Lichtsteuer- oder Sensorbusses können entweder die einzelnen Leuchtmodule oder das Kontaktierungshaltesystem entsprechende Logikschaltungen aufweisen, um eine Ansteuerung der Leuchtmodule zu ermöglichen, die unabhängig von der Steuerung anderer Leuchtmodule ist, beispielweise ein Ein- und Ausschalten einzelner Module oder ein Dimmen einzelner Module.

Bei Ausführungsbeispielen der vorliegenden Erfindung weisen die Leuchtmodule einen Modulkörper auf, dessen Hauptflächen rechteckig, insbesondere quadratisch sind. Bei alternativen Ausführungsbeispielen können die Hauptflächen mehreckig ausgeführt sein, beispielsweise hexagonförmig oder oktogonförmig. Vorzugsweiseliegen zumindest zwei Seiten einander im Wesentlichen parallel gegenüber, so dass eine verpolsichere Verschaltung unabhängig von zumindest zwei möglichen Ausrichtungen des Modulkörpers erreicht werden kann.

Ausführungsbeispiele schaffen somit OLED-Flächen, die mittels kleinerer OLED-Module unterteilt sind, wobei das OLED-Modulsystem lösbar oder nicht lösbar kontaktiert aufgebaut werden kann. Bei Ausführungsbeispielen sind die OLED-Module austauschbar ausgelegt, um einen Austausch aufgrund der begrenzten Lebensdauer zu ermöglichen. Ausführungsbeispiele der vorliegenden Erfindung ermöglichen, dass eine lösbare Verbindung verpolungssicher aufgebaut wird. Große OLED-Flächen können realisiert werden, mit der Möglichkeit, einzelne OLED-Module auszutauschen. Ausführungsbeispiele der vorliegenden Erfindung bieten ferner die Möglichkeit, neben der elektrischen Kontaktierung auch professionelle Lichtansteuerungen, beispielsweise in Form eines Zweidraht-Busses (beispielsweise eines Dali-Busses oder DMX-Busses) zu integrieren.

Bei den beschriebenen Ausführungsbeispielen der Erfindung sind die jeweiligen Anschlüsse auf einer Unterseite des Leuchtmoduls angeordnet. Bei alternativen Ausführungsbeispielen können die Anschlüsse auch auf Seitenflächen, die die beiden Hauptoberflächen verbinden, angeordnet sein, wenn die entsprechenden Kontaktierungspunkte auch einem Kontaktierungshaltersystem dazupassend angeordnet sind, beispielsweise auf den Seitenwänden jeweiliger Ausnehmungen in dem Kontaktierungshaltersystem. Unter Hauptflächen sind dabei hierin die, in der Regel parallelen, Flächen des Modulkörpers zu verstehen, die die größte Fläche aufweisen.

Bezugnehmend auf die Fig. 7a, 7b und 8a, 8b wurden Ausführungsbeispiele beschrieben, bei denen Steuerbusanschlüsse 86, 88, 86' und 88' zwischen Stromversorgungsanschlüssen 82, 84, 82', 84' angeordnet sind. Bei alternativen Ausführungsbeispielen sind andere Anordnungen möglich, beispielsweise können die Stromversorgungsanschlüsse 82, 84, 82', 84' benachbart zueinander nebeneinander angeordnet sein und die Steuerbusanschlüsse auf einer Seite oder beiden Seiten derselben angeordnet sein.

## Patentansprüche

1. Leuchtmodul (10) mit:
einem Modulkörper (20),
einem ersten Anschlusspaar bestehend aus einem ersten Stromzuleitungsanschluss (A₁; 82) und einem ersten Stromableitungsanschluss (K₁; 84),
mindestens einem zweiten Anschlusspaar bestehend aus einem zweiten Stromzuleitungsanschluss (A₂; 82') sowie einem zweiten Stromableitungsanschluss (K₂; 84'),
wobei die Anordnung der Anschlusspaare an dem Modulkörper (20) eine der Anzahl n der Anschlusspaare entsprechende n-zählige Drehsymmetrie aufweist und wobei die Stromzuleitungsanschlüsse (A₁ bis A₄; 82, 82') und die Stromableitungsanschlüsse (K₁ bis K₄; 84, 84') auf einer Hauptoberfläche des Modulkörpers (20) gebildet sind,
**dadurch gekennzeichnet,**
**dass** sich der erste und zweite Stromzuleitungsanschluss (A₁, A₂; 82, 82') von der jeweils benachbarten Seite (22, 24) unterschiedlich weit in Richtung zu der gegenüberliegenden Seite erstrecken, als sich der erste und der zweite Stromableitungsabschnitt (K₁, K₂; 84, 84') von der jeweils benachbarten Seite zu der gegenüberliegenden Seite erstrecken.

2. Leuchtmodul nach Anspruch 1,
wobei die Anschlusspaare an Seiten bzw. Seitenabschnitten des Modulkörpers (20) angeordnet sind und die Form des Modulkörpers (20) selbst eine n-zählige Drehsymmetrie aufweist.

3. Leuchtmodul (10) nach Anspruch 1 oder 2,
wobei der Modulkörper (20) zumindest vier Seiten (22, 24, 26, 28) aufweist, von denen sich eine erste Seite (22) und eine zweite Seite (24) gegenüberliegen; wobei
• der erste Stromzuleitungsanschluss (A₁; 82) benachbart zu der ersten Seite (22) gebildet ist;
• der zweite Stromzuleitungsanschluss (A₂; 82') benachbart zu der zweiten Seite (24) gebildet ist;
• der erste Stromableitungsanschluss (K₁; 84) benachbart zu der ersten Seite (22) gebildet ist; und
• der zweite Stromableitungsanschluss (K₂; 84') benachbart zu der zweiten Seite gebildet ist;
und wobei sich der erste Stromzuleitungsanschluss (A₁; 82) und der zweite Stromableitungsanschluss (K₂; 84') gegenüberliegen und wobei sich der zweite Stromzuleitungsanschluss (A₂; 82') und der erste Stromableitungsanschluss (K₁; 84) gegenüberliegen.

4. Leuchtmodul nach Anspruch 3, bei dem der Modulkörper (20) eine dritte und vierte Seite (26, 28) aufweist, die sich gegenüberliegen, mit ferner folgenden Merkmalen:
einem dritten Stromzuleitungsanschluss (A₃), der benachbart zu der dritten Seite (26) gebildet ist;
einem vierten Stromzuleitungsanschluss (A₄), der benachbart zu der vierten Seite (28) gebildet ist;
einem dritten Stromableitungsanschluss (K₃), der benachbart zu der dritten Seite (26) gebildet ist; und
einem vierten Stromableitungsanschluss (K₄), der benachbart zu der vierten Seite (28) gebildet ist,
wobei sich der dritte Stromzuleitungsanschluss (A₃) und der vierte Stromableitungsanschluss (A₄) gegenüberliegen und wobei sich der vierte Stromzuleitungsanschluss (A₄) und der dritte Ableitungsanschluss (K₄) gegenüberliegen.

5. Leuchtmodul nach einem der vorhergehenden Ansprüche, das eine lichtemittierende Diode aufweist, wobei die Stromzuleitungsanschlüsse Anodenanschlüsse und die Stromableitungsanschlüsse Kathodenanschlüsse sind.

6. Leuchtmodul nach Anspruch 5, das folgende Merkmale aufweist:
eine organische lichtemittierende Diode (60) mit einem aktiven Bereich zwischen einer ersten leitfähigen Schicht und einer zweiten leitfähigen Schicht; und
eine Platine (66), auf der die Kathodenanschlüsse und die Anodenanschlüsse gebildet sind, wobei die Kathodenanschlüsse mit der ersten leitfähigen Schicht und die Anodenanschlüsse mit der zweiten leitfähigen Schicht elektrisch verbunden sind.

7. Leuchtmodul nach einem der Ansprüche 1 bis 6, das ferner folgende Merkmale aufweist:
zumindest einen Steuerbusanschluss (86, 88), der benachbart zu der ersten Seite (22) angeordnet ist, und zumindest einen zweiten Steueranschluss (86', 88'), der benachbart zu der zweiten Seite gegenüber dem ersten Steuerbusanschluss angeordnet ist.

8. Leuchtmodul nach Anspruch 7, das zwei Steuerbusanschlüsse (86, 88), die benachbart zu der ersten Seite (22) angeordnet sind, aufweist, die zwei Steuerbusanschlüssen (86', 88'), die benachbart zu der zweiten Seite angeordnet sind, gegenüberliegen.

9. Leuchtmodul nach einem der Ansprüche 7 oder 8, bei dem sich zumindest ein Steuerbusanschluss (88) weiter von der ihm benachbarten Seite (22) in Richtung zu der gegenüberliegenden Seite (24) erstreckt als ein Steuerbusanschluss (88'), der bei einer Drehung des Leuchtmoduls um 180° an der Position dieses Steuerbusanschlusses (88) zu liegen kommt.

10. Leuchtmodul nach einem der Ansprüche 7 bis 9, das eine Logik aufweist, die konfiguriert ist, um das Leuchtmodul basierend auf Steuersignalen, unabhängig von den anderen Leuchtmodulen zu steuern.

11. Leuchte mit folgenden Merkmalen:
einer Mehrzahl von Leuchtmodulen (10) nach einem der Ansprüche 1 bis 10; und
Verbindungsstrukturen (44; 90; 92, 92'), die einen Stromableitungsanschluss eines vorgeschalteten Leuchtmoduls jeweils mit einem Stromzuleitungsanschluss eines nachgeschalteten Leuchtmoduls elektrisch verbinden, so dass die Leuchtmodule in Reihe geschaltet sind.

12. Leuchte nach Anspruch 11, bei der die Verbindungsstrukturen (90) ausgelegt sind, um eine nichtlösbare Verbindung zu liefern.

13. Leuchte nach Anspruch 12, bei der die Verbindungsstrukturen (92, 92') ausgelegt sind, um eine lösbare Verbindung zu liefern.

14. Leuchte nach Anspruch 13, bei der die Verbindungsstrukturen Federkontakte (92, 92') aufweisen.

15. Leuchte nach einem der Ansprüche 11 bis 14 mit einer Verbindungsstrukturhaltevorrichtung, die Verbindungsstrukturen für eine Mehrzahl von Leuchtmodulen aufweist und die für eine mechanische Kopplung mit der Mehrzahl von Leuchtmodulen ausgelegt ist, so dass diese durch die Verbindungsstrukturen in Reihe geschaltet sind.

## Claims

1. A lighting module (10) having:
a module body (20),
a first pair of connections consisting of a first power-supply connection (A₁; 82) and a first power-tapping connection (K₁; 84),
at least one second pair of connections consisting of a second power-supply connection (A₂; 82') and also a second power-tapping connection (K₂; 84'),
wherein the arrangement of the pairs of connections on the module body (20) has an n-fold rotational symmetry corresponding to the number n of the pairs of connections,
and wherein the power-supply connections (A₁ to A₄; 82, 82') and the power-tapping connections (K₁ to K₄; 84, 84') are formed on a main surface of the module body (20),
**characterised in that**
the first and second power-supply connection (A₁, A₂; 82, 82') extend from the respectively adjacent side (22, 24) in the direction of the opposing side to a different extent from that to which the first and the second power-tapping section (K₁, K₂; 84, 84') extend from the respectively adjacent side to the opposing side.

2. A lighting module according to claim 1,
wherein the pairs of connections are arranged on sides or side sections of the module body (20), and the form of the module body (20) itself has an n-fold rotational symmetry.

3. A lighting module (10) according to claim 1 or 2,
wherein the module body (20) has at least four sides (22, 24, 26, 28), of which a first side (22) and a second side (24) lie opposite each other;
wherein
• the first power-supply connection (A₁; 82) is formed adjacently to the first side (22);
• the second power-supply connection (A₂; 82') is formed adjacently to the second side (24);
• the first power-tapping connection (K₁; 84) is formed adjacently to the first side (22); and
• the second power-tapping connection (K₂; 84') is formed adjacently to the second side;
and wherein the first power-supply connection (A₁; 82) and the second power-tapping connection (K₂; 84') lie opposite each other, and wherein the second power-supply connection (A₂; 82') and the first power-tapping connection (K₁; 84) lie opposite each other.

4. A lighting module according to claim 3, in which the module body (20) has a third and fourth side (26, 28) that lie opposite each other, having further the following features:
a third power-supply connection (A₃) which is formed adjacently to the third side (26);
a fourth power-supply connection (A₄) which is formed adjacently to the fourth side (28);
a third power-tapping connection (K₃) which is formed adjacently to the third side (26); and
a fourth power-tapping connection (K₄) which is formed adjacently to the fourth side (28),
wherein the third power-supply connection (A₃) and the fourth power-tapping connection (A₄) lie opposite each other, and wherein the fourth power-supply connection (A₄) and the third tapping connection (K₄) lie opposite each other.

5. A lighting module according to one of the preceding claims that has a light-emitting diode, wherein the power-supply connections are anode connections, and the power-tapping connections are cathode connections.

6. A lighting module according to claim 5 that has the following features:
an organic light-emitting diode (60) having an active region between a first conductive layer and a second conductive layer;
and
a printed circuit board (66) on which the cathode connections and the anode connections are formed,
wherein the cathode connections are electrically connected to the first conductive layer, and the anode connections are electrically connected to the second conductive layer.

7. A lighting module according to one of claims 1 to 6 that has further the following features:
at least one control-bus connection (86, 88), which is arranged adjacently to the first side (22), and at least one second control connection (86', 88'), which is arranged adjacently to the second side opposite the first control-bus connection.

8. A lighting module according to claim 7 that has two control-bus connections (86, 88), which are arranged adjacently to the first side (22), lying opposite two control-bus connections (86', 88'), which are arranged adjacently to the second side.

9. A lighting module according to one of claims 7 or 8, in which at least one control-bus connection (88) extends further from the side (22) adjacent to it in the direction of the opposing side (24) than a control-bus connection (88'), which in the case of a rotation of the lighting module about 180° comes to lie at the position of this control-bus connection (88).

10. A lighting module according to one of claims 7 to 9, that has a logic unit configured to control the lighting module on the basis of control signals, independently of the other lighting modules.

11. A luminaire having the following features:
a plurality of lighting modules (10) according to one of claims 1 to 10;
and
connecting structures (44; 90; 92, 92') electrically connecting in each case a power-tapping connection of a lighting module connected upstream to a power-supply connection of a lighting module connected downstream so that the lighting modules are connected in series.

12. A luminaire according to claim 11, in which the connecting structures (90) are designed in order to deliver a non-detachable connection.

13. A luminaire according to claim 12, in which the connecting structures (92, 92') are designed in order to deliver a detachable connection.

14. A luminaire according to claim 13, in which the connecting structures have spring contacts (92, 92').

15. A luminaire according to one of claims 11 to 14 having a connecting-structure holding device that has connecting structures for a plurality of lighting modules and is designed for a mechanical coupling with the plurality of lighting modules so that the latter are connected in series by means of the connecting structures.

## Revendications

1. Module d'éclairage (10) comprenant :
un corps de module (20),
une première paire de bornes de connexion constituée d'une première borne de connexion à l'arrivée de courant (A₁ ; 82) et d'une première borne de connexion à la sortie de courant (K₁ ; 84),
au moins une deuxième paire de bornes de connexion constituée d'une deuxième borne de connexion à l'arrivée de courant (A₂ ; 82') ainsi que d'une deuxième borne de connexion à la sortie de courant (K₂ ; 84'),
sachant que l'ensemble des paires de bornes de connexion présente, au niveau du corps de module (20), une symétrie de rotation de valeur n correspondant au nombre n des paires des bornes de connexion,
et sachant que les bornes de connexion à l'arrivée de courant (A₁ à A₄ ; 82, 82') et les bornes de connexion à la sortie de courant (K₁ à K₄ ; 84, 84') sont formées sur une surface principale du corps de module (20),
**caractérisé en ce**
**que** la première et la deuxième borne de connexion à l'arrivée de courant (A₁, A₂ ; 82, 82') s'étendent à des distances différentes du côté (22, 24) respectivement adjacent en direction du côté opposé, tandis que la première et la deuxième borne de connexion à la sortie de courant (K₁ à K₄ ; 84, 84') s'étendent depuis le côté respectivement adjacent en direction du côté opposé.

2. Module d'éclairage selon la revendication 1,
sachant que les paires de bornes de connexion sont disposées au niveau de côtés ou des sections de côtés du corps de module (20), et en ce que la forme du corps de module (20) présente lui-même une symétrie de rotation de valeur n.

3. Module d'éclairage (10) selon la revendication 1 ou 2,
sachant que le corps de module (20) présente au moins quatre côtés (22, 24, 26, 28), parmi lesquels un premier côté (22) et un deuxième côté (24) se font face,
sachant que
- la première borne de connexion à l'arrivée de courant (A₁ ; 82) est formée de manière adjacente au premier côté (22),
- la deuxième borne de connexion à l'arrivée de courant (A₂ ; 82') est formée de manière adjacente au deuxième côté (24),
- la première borne de connexion à la sortie de courant (K2 ; 84) est formée de manière adjacente au premier côté (22) ; et
- la deuxième borne de connexion à la sortie de courant (K₂ ; 84') est formée de manière adjacente au deuxième côté ;
et sachant que la première borne de connexion à l'arrivée de courant (A₁ ; 82) et la deuxième borne de connexion à la sortie de courant (K₂ ; 84') se font face et sachant que la deuxième borne de connexion à l'arrivée de courant (A₂ ; 82') et la deuxième borne de connexion à la sortie de courant (K₁ ; 84) se font face.

4. Module d'éclairage selon la revendication 3, dans le cadre duquel le corps de module (20) présente un troisième et un quatrième côté (26, 28), qui se font face, présentant en outre les caractéristiques qui suivent :
une troisième borne de connexion à l'arrivée de courant (A₃), qui est formée de manière adjacente au troisième côté (26) ;
une quatrième borne de connexion à l'arrivée de courant (A₄), qui est formée de manière adjacente au quatrième côté (28) ;
une troisième borne de connexion à la sortie de courant (K₃), qui est formée de manière adjacente au troisième côté (26) ; et
une quatrième borne de connexion à la sortie de courant (K₄), qui est formée de manière adjacente au quatrième côté (28),
sachant que la troisième borne de connexion à l'arrivée de courant (A₃) et la quatrième borne de connexion à la sortie de courant (A₄) se font face et sachant que la quatrième borne de connexion à l'arrivée de courant (A₄) et la troisième borne de connexion à la sortie de courant (K₄) se font face.

5. Module d'éclairage selon l'une quelconque des revendications précédentes, qui présente une diode électroluminescente, sachant que les bornes de connexion à l'arrivée de courant sont des bornes d'anode et que les bornes de connexion à la sortie de courant sont des bornes de cathode.

6. Module d'éclairage selon la revendication 5, lequel présente les caractéristiques qui suivent :
une diode électroluminescente (60) organique pourvue d'une zone active entre une première couche conductrice et une deuxième couche conductrice,
et une platine (66), sur laquelle sont formées les bornes de cathode et les bornes d'anode, sachant que les bornes de cathode sont raccordées électriquement à la première couche conductrice et que les bornes d'anode sont raccordées électriquement à la deuxième couche conductrice.

7. Module d'éclairage selon l'une quelconque des revendications 1 à 6, lequel présente en outre les caractéristiques qui suivent :
au moins une borne de connexion au bus de commande (86, 88), qui est disposée de manière adjacente au premier côté (22), et au moins une deuxième borne de connexion de commande (86', 88'), qui est disposée de manière adjacente au deuxième côté, par rapport à la première borne de connexion au bus de commande.

8. Module d'éclairage selon la revendication 7, qui présente deux bornes de connexion au bus de commande (86, 88), qui sont disposées de manière adjacente au premier côté (22), lesquelles font face aux deux bornes de connexion au bus de commande (86', 88'), qui sont disposées de manière adjacente au deuxième côté.

9. Module d'éclairage selon l'une quelconque des revendications 7 ou 8, dans le cadre duquel au moins une borne de connexion au bus de commande (88) s'étend davantage depuis le côté (22) qui lui est adjacent en direction du côté faisant face (24) qu'une borne de connexion au bus de commande (88') qui , en cas d'une rotation du module d'éclairage de 180°, parvient au niveau de la position de ladite borne de connexion au bus de commande (88).

10. Module d'éclairage selon l'une quelconque des revendications 7 à 9, lequel présente une logique, qui est configurée pour commander le module d'éclairage sur la base des signaux de commande indépendamment des autres modules d'éclairage.

11. Appareil d'éclairage présentant les caractéristiques qui suivent :
une pluralité de modules d'éclairage (10) selon l'une quelconque des revendications 1 à 10, et
des structures de raccordement (44 ; 90 ; 92, 92'), qui raccordent électriquement une borne de connexion à la sortie de courant d'un module d'éclairage installé en amont respectivement à une borne de connexion à l'arrivée de courant d'un module d'éclairage installé en aval, de sorte que les modules d'éclairage sont branchés en série.

12. Appareil d'éclairage selon la revendication 11, dans le cadre duquel les structures de raccordement (90) sont configurées pour offrir un raccordement non amovible.

13. Appareil d'éclairage selon la revendication 12, dans le cadre duquel les structures de raccordement (92, 92') sont configurées pour offrir un raccordement amovible.

14. Appareil d'éclairage selon la revendication 13, dans le cadre duquel les structures de raccordement présentent des contacts à ressort (92, 92').

15. Appareil d'éclairage selon l'une quelconque des revendications 11 à 14, comprenant
un dispositif de maintien de structure de raccordement, lequel présente des structures de raccordement pour une pluralité de modules d'éclairage et qui est configuré en vue d'un couplage mécanique à la pluralité de modules d'éclairage, de sorte que ces derniers sont branchés en série par les structures de raccordement.
